Europäisches Patentamt

European Patent Office

Office européen des brevets

(19)

(11) Veröffentlichungsnummer: **0 1 1 7 421**
**B1**

(12)    # EUROPÄISCHE PATENTSCHRIFT

(45) Veröffentlichungstag der Patentschrift:
09.04.86

(51) Int. Cl.⁴: **G 01 R 23/00, G 01 R 29/16**

(21) Anmeldenummer: 84100678.6

(22) Anmeldetag: 23.01.84

(54) **Verfahren und Vorrichtung zur rauscharmen Frequenzmessung bei einer mehrphasigen elektrischen Leistungsübertragung.**

(30) Priorität: 02.02.83 DE 3303454

(43) Veröffentlichungstag der Anmeldung:
05.09.84 Patentblatt 84/36

(45) Bekanntmachung des Hinweises auf die Patenterteilung:
09.04.86 Patentblatt 86/15

(84) Benannte Vertragsstaaten:
CH DE FR GB LI SE

(56) Entgegenhaltungen:
DE - A - 2 019 263
US - A - 3 699 441
US - A - 4 322 806

(73) Patentinhaber: Siemens Aktiengesellschaft, Berlin und München Wittelsbacherplatz 2, D-8000 München 2 (DE)

(72) Erfinder: Hosemann, Gerhard, Prof., Dr.-Ing.,
Weiherackerweg 36, D-8521 Rathsberg (DE)

**Beschreibung**

Die Erfindung betrifft ein Verfahren zur Frequenzmessung bei einem mehrphasigen Leitungssystem zur Übertragung elektrischer Leistung sowie eine Vorrichtung zur Durchführung de Verfahrens.

Zur Beurteilung der elektromechanischen Ausgleichsvorgänge und der Leistungsbilanz bei der Übertragung elektrischer Leistung, z.B. von den Turbinen eines Kraftwerks in ein elektrisches Versorgungsnetz, wird häufig eine Frequenzmessung benötigt, um z.B. festzustellen, ob die Turbinenleistung mit der Verbraucherleistung übereinstimmt. Für die Turbinenleistung ist in erster Linie die Drehgeschwindigkeit der Antriebsmaschinen entscheidend, die sich aber nur im Kraftwerk selbst unmittelbar erfassen läßt. Je nach Art und Lastzustand der Verbraucher treten zwischen dem Kraftwerk und dem Versorgungsnetz elektromagnetische Ausgleichsvorgänge auf, die in der Übertragungsleitung zu Verschiebungen der Phase bzw. Frequenz der Spannungen und Ströme führen und daher die Frequenzmessung verfälschen. Für die Leistungsbilanz und ihre Veränderungen ist die Phasenzahl des elektromagnetischen Übertragungssystems im Grundsatz nebensächlich, jedoch läßt sich eine rauscharme-Frequenzmessung nicht an einer einzelnen Phase und nicht allein durch Messung des zeitlichen Abstandes der Nulldurchgänge nur einer einzigen schwingenden Größe durchführen. Je nach Art und Zustand der Verbraucher treten nämlich Unter- und Oberschwingungen auf, die die Nulldurchgänge verschieben. Das an derartigen Übertragungsleitungen auftretende Frequenz- oder Phasenrauschen muß demnach ausgefiltert werden. Auch können Netzunsymmetrien bis hin zu unsymmetrischen Netzkurzschlüssen oder Leiterunterbrechungen eintreten, und um nun auch in derartigen Fällen eine zuverlässige Frequenzmessung durchführen zu können, müssen z.B. bei einem Drehspannungssystem die für die Überwachung geeigneten Spannungen aus den insgesamt zur Verfügung stehenden 6 Leiter- und Leitererdspannungen ausgewählt werden.

Der Erfindung liegt daher die Aufgabe zugrunde, bei einer Übertragung elektrischer Leistung außerhalb des Kraftwerks eine Größe festzustellen und zu messen, die der Drehgeschwindigkeit der Antriebsmaschinen möglichst genau entspricht und nicht durch elektromagnetische Einflüsse wie Unter- und Oberschwingungen, Netzunsymmetrien, Netzfehler und andere Verbrauchereigenschaften verfälscht wird. Je besser dabei das Frequenz- und Phasenrauschen durch geeignete Meßeinrichtungen unterdrückt werden kann, desto leichter lassen sich dann kritische Zustände des elektromechanischen Übertragungssystems erkennen. Diese Aufgabe wird gelöst durch ein Verfahren mit den Merkmalen des Anspruchs 1.

Die Erfindung geht dabei von der Erkenntnis aus, daß als derartige Größe die Frequenz der mitlaufenden ("positivsequenten") Komponente des Drehstromsystems besonders geeignet ist. Ihr zeitlicher Mittelwert ist frei von allen aufgeführten Störgrößen und kennzeichnet so den elektromechanischen Zustand der Leistungsübertragung vom Kraftwerk zum Verbraucher am besten. Daher wird gemäß der Erfindung die Frequenzmessung einer mehrphasigen elektrischen Energieübertragung auf die symmetrische Komponente ausgerichtet. Eine weitere besondere Auswahl aus den Leiter- und Leitererdspannungen wird dann überflüssig. Die zugrunde liegende Aufgabe ist somit auf das Problem reduziert, die grundschwingung der Mitkomponente von den noch vorhandenen Unter- und Oberschwingungen zu separieren und ihre Rotation zu messen. Zur Separation könnte man Bandfilter vorsehen, solche Filter wirken jedoch unvollkommen und nur verzögert.

Aus der deutschen Offenlegungsschrift 20 19 263 ist eine Einrichtung zum phasenrichtigen Glätten von Vektorkomponenten-Bpannungen bekannt. Dabei werden zwei Spannungen, die als orthogonale Komponenten $|E|. \cos \varepsilon, |E|. \sin \varepsilon$ eines Vektors in einem raumfesten orthogonalen Bezugssystem aufgefaßt werden, in einem Vektordreher durch Multiplikation mit zwei Spannungen, die als orthogonale Komponenten $\cos \alpha, \sin \alpha$ eines normierten Vektors (Transformationsvektor) eingegeben werden, in die entsprechenden orthogonalen Komponenten $|E|. \cos (\varepsilon - \alpha), |E|. \sin (\varepsilon - \alpha)$ des eingegebenen Vektors in einem mit dem Transformationsvektor phasenstarr rotierenden Bezugssystem umgerechnet. Der Realteil $|E|. \cos (\varepsilon - \alpha)$ dieses transformierten Vektors wird als Sollwert einem PI-Regler eingegeben, dessen Ausgangssignal integriert und als Istwert dem Regler rückgeführt wird. Bei verschwindender Regelabweichung zwischen dem eingegebenen Vektor und dem Transformationsvektor ($\varepsilon - \alpha = 0$) entspricht somit der Realteil dem gemittelten Betrag des Vektors, wobei diese Mittelung jedoch nicht im raumfesten, orthogonalen Bezugssystem, sondern in dem mit dem Transformationsvektor phasenstarr rotierenden Bezugssystem durchgeführt wird. Aus dem Imaginärteil des transformierten Vektors wird durch Division mit dem Realteil die Größe $\tan (\varepsilon - \alpha)$ gebildet, die einem weiteren PI-Regler zugeführt wird. Das Ausgangssignal dieses Reglers wird als frequenzproportionale Steuerspannung $\alpha$ einem Sinus- und Cosinusgenerator zugeführt, dessen Ausgangssignal $\cos \alpha, \sin \alpha$ als die entsprechenden orthogonalen, raumfesten Komponenten des Transformationsvektors dem Winkelsignaleingang des erwähnten Vektordrehers zugeführt sind.

Dieser zweite PI-Regler regelt somit die Richtungsabweichung ($\varepsilon-\alpha$) dadurch zu Null aus, daß die Frequenz des Transformationsvektors solange verändert wird, bis der Transformationsvektor im Mittel synchron mit dem eingegebenen Vektor umläuft. Im stationären Fall gibt somit der Transformationsvektor stets ohne Phasenverschiebung die Richtung des eingegebenen Vektors wieder, wobei überlagerte Ober- und Unterschwingungen des Vektors ausgemittelt werden. Durch Multiplikation der Komponenten des Transformationsvektors mit dem mittleren Betrag des Vektors werden dann die orthogonalen Komponenten des gefilterten Vektors gebildet.

Gemäß der Erfindung kann zur Frequenzmessung an einem mehrphasigen Leitungssystem zur elektrischen Leistungsübertragung ähnlich vorgegangen werden, wobei in einer raumfesten Betrachtung von den Orthogonalkomponenten eines nullpunktfreien Meßwertsystems ausgegangen wird, das aus den am Leitungssystem abgegriffenen Meßwerten gebildet wird. Die Bezeichnungen "Orthogonalkomponente", "Mitkomponente" und "Raumzeiger" sind dabei nach DIN 13 321 gewählt. Werden für die Leitererdspannungen oder andere elektrische Meßgrößen des Leitungssystems die skalaren Meßwerte $g_R$, $g_S$, $g_T$ bzw. für die entsprechenden verketteten Größen die skalaren Meßwerte $g_{SR}$, $g_{TR}$, $g_{ST}$ erfaßt und wird mit $\underline{a} = \exp(j\,2\pi/3)$ eine Transformationsgröße bezeichnet, deren Realteil und Imaginärteil als entsprechende Spannungen einem Koordinatenwandler eingegeben werden, so ist die Mitkomponente $\underline{g}_1$ durch die Beziehungen in üblicher leistungsvarianter Schreibweise

$$3\,\underline{g}_1 = g_R + \underline{a}\,g_S + \underline{a}^2\,g_T = \underline{a}\,g_{SR} + \underline{a}^2\,g_{TR}$$

$$\underline{g}_1 = -\underbrace{\frac{1}{6}\,(g_{SR} + g_{TR})}_{\dfrac{g_\alpha}{\sqrt{6}}} + \underbrace{j\,\frac{1}{2\sqrt{3}}\,(g_{SR} - g_{TR})}_{\dfrac{g_\beta}{\sqrt{6}}}$$

definiert, wobei mit $g_\alpha$ und $g_\beta$ die "Orthogonalkomponenten" (leistungsinvariante Form) gegeben sind. Diese Orthogonalkomponenten gestatten es, in einer raumfesten Betrachtungsweise das nullpunktfreie Meßwertsystem durch Realteil und Imaginärteil einer komplexen Zahl vollständig darzustellen. Unter einem "nullpunktfreien" System ist dabei ein System verstanden, bei dem die "Nullkomponente", d.h. die Summe aller skalaren Meßwerte, gleich Null ist, wie dies z.B. für die verketteten Leiterspannungen der Fall ist. Ein nullpunktbehaftetes Meßwertsystem stellt sich dabei als Überlagerung der Nullkomponente mit dem nullpunktfreien System dar. Bei der durch die angegebenen Beziehungen definierten Darstellung der Mitkomponente ist die Nullpunktfreiheit wegen der mathematischen

Beziehung $(1 + \underline{a} + \underline{a}^2) = 0$ gewährleistet.

Derartige Koordinatenwandler, die die Orthogonalkomponenten $g_\alpha$ $g_\beta$ entsprechend den o.g. Beziehungen liefern, sind bekannt.

Der Raumzeiger $\underline{g}_s$ ist nach der erwähnten Norm durch die komplexe Beziehung

$$\underline{g}_s = \frac{g_\alpha + j g_\beta}{\sqrt{2}} \cdot \exp(-j\omega t)$$
$$= \frac{1}{\sqrt{3}}\,\big[(g_\alpha \cos\omega t + g_\beta \sin\omega t) + j(-g_\alpha \sin\omega t + g_\beta \cos\omega t)\big]$$

gegeben. Dies entspricht einer Transformation der bei der raumfesten Darstellung gefundenen Orthogonalkomponenten in frequenztransformierte Komponenten, bei der eine mit der Frequenz $\omega t$ veränderliche Größe nunmehr in eine konstante Größe transformiert (demoduliert) wird. Diese, durch $\exp(-j\omega t)$ gegebene Transformation entspricht einer Transformationsmatrix, deren Elemente durch $\cos\omega t$, $\sin\omega t$ gegeben ist.

Auf die Orthogonalkomponenten angewendet, ergibt diese Transformation den Raumzeiger. Beim erfindungsgemäßen Verfahren werden aus einer intern gebildeten Stellgröße zwei mit einer der Stellgröße proportionalen Frequenz veränderliche Wechselgrößen als Elemente einer entsprechenden Transformationsmatrix gebildet, um aus den Orthogonalkomponenten und diesen Transformationselementen eine richtungsbestimmende Größe des den Orthogonalkomponenten zugeordneten Raumzeigers zu bilden.

Der Raumzeiger liegt z.B. vollständig in der reellen Achse, wenn gilt
Im $(\underline{g}_s) = -g_\alpha \sin\omega t + g_\beta \cos\omega t = 0$.
Dadurch ist die Richtung des Raumzeigers in dem dieser Transformation zugehörigen Bildraum festgelegt. Die Stell-größe wird nun durch eine Regelung gebildet, der als Istwert der Imaginärteil des Raumzeigers und als Sollwert der Wert Null vorgegeben wird. Dadurch wird die der Transformation zugrunde gelegte Frequenz so nachgeführt, daß der Raumzeiger stets in die Richtung der imaginären Achse zeigt.

Die stellgrößenproportionale Frequenz $\omega$, die diese Bedingung erfüllt, ist gerade die Drehgeschwindigkeit der Mitkomponente des Übertragungssystems. Damit ist die gesuchte rauscharme Kreisfrequenz des elektromechanischen Systems bestimmt. Folglich braucht als Meßgröße für die Frequenz des Übertragungssystems lediglich noch die frequenzproportionale Stellgröße am Reglerausgang abgegriffen zu werden. Deren zeitliche Ableitung ist die Winkelbeschleunigung des Mitsystems; sie ist bei Leistungsdefizit negativ, bei Leistungsüberschuß positiv.

Zweckmäßig wird die Frequenz in einen vorgegebenen konstanten Anteil $\omega_N$ (Nennfrequenz des Netzes) und einen veränderlichen Anteil $\delta$ unterteilt, wobei durch die Regelung nur $\delta$ bestimmt wird. Dessen zeitliches Integral $\delta$. dt gibt den Gangunterschied (Phasendifferenz) zwischen dem Übertragungssystem und dem Versorgungsnetz an.

An Stelle des Realteils des Raumzeigers kann aber der Imaginärteil oder auch eine andere Größe, die die Richtung des Raumzeigers im Bildraum der Transformation festlegt, gewählt werden, wobei durch Vorgabe eines entsprechenden konstanten Sollwertes ebenfalls gewährleistet ist, daß der zeitlich gemittelte Raumzeiger stets in dieselbe Richtung weist.

Eine vorteilhafte Vorrichtung zur Durchführung des Verfahrens sowie Weiterbildungen der Erfindung sind in den Unteransprüchen gekennzeichnet und werden anhand von zwei Figuren näher erläutert.

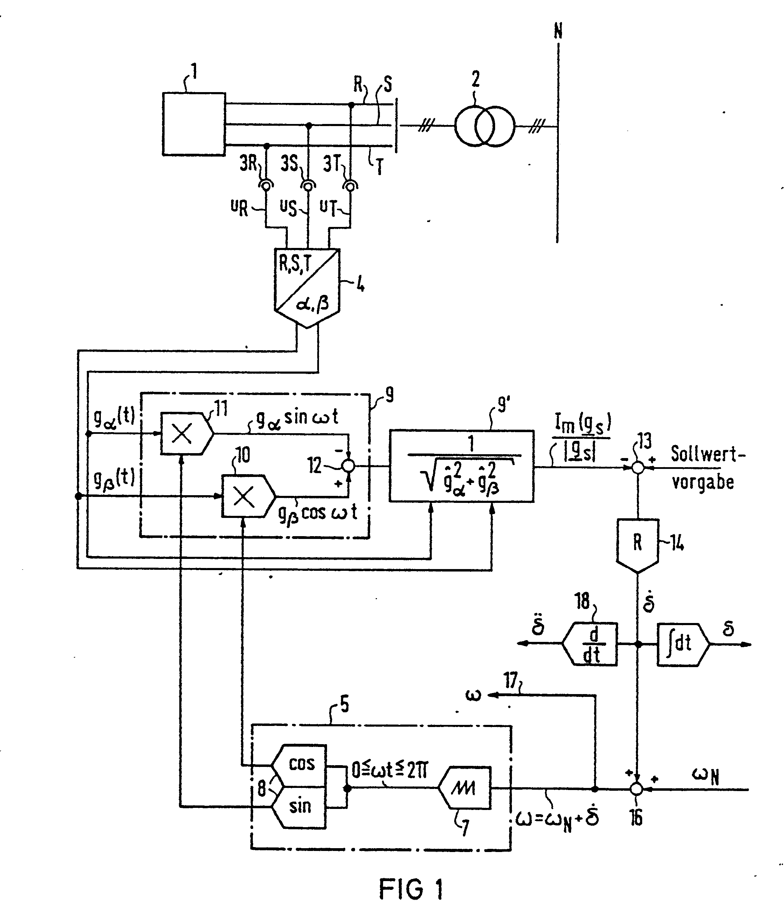

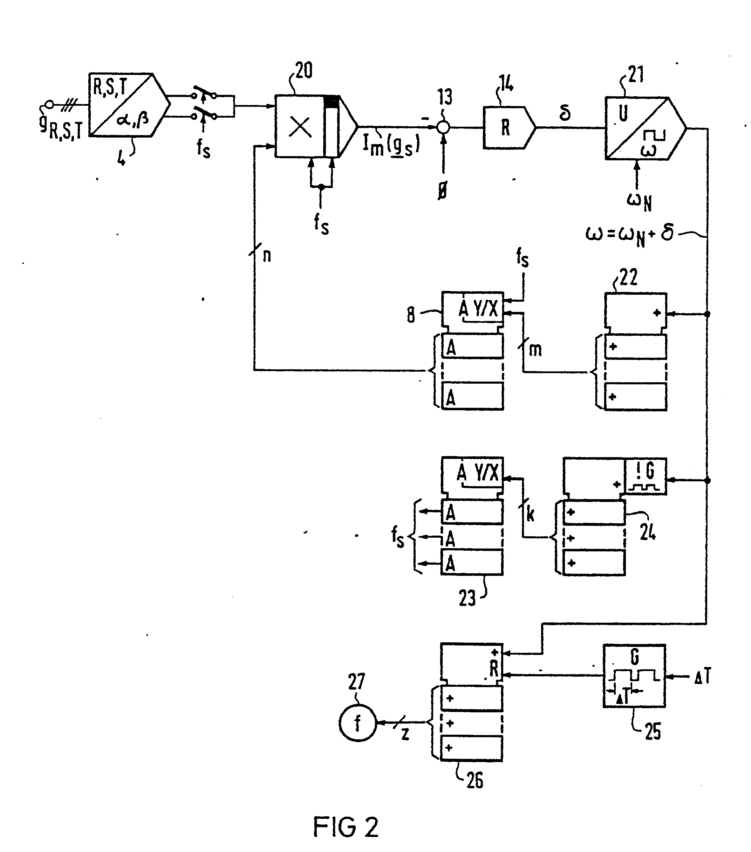

Fig. 1 zeigt schematisch den Aufbau einer Vorrichtung zur Durchführung des Verfahrens, Fig. 2 zeigt eine digitalisierte Ausführungsform.

Gemäß Fig. 1 ist ein Leistungserzeuger oder - verbraucher 1 über die Außenleiter R, S, T eines dreiphasigen Leitungssystems und eine Ankoppeleinheit 2 an ein Versorgungsnetz N angeschlossen. Im gezeigten Fall wird von Meßwerten der Leitererdspannungen $u_R$, $u_S$, $u_T$ ausgegangen, die mittels Meßwandler 3R, 3S, 3T abgegriffen und einem 3/2-Koordina-tenwandler 4 zugeführt werden. Dadurch werden praktisch unverzögert die raumfesten Orthogonalkomponenten $g\alpha$ (t) und $g\beta$ (t) eines dem Leitungssystem R, S, T zugeordneten nullpunktfreien Systems geliefert.

Gleichzeitig liefert ein einen integrierenden Funktionsgeber enthaltendes Stellglied 5 die Transformationselemente für eine Transformation der raumfesten Orthogonalkomponenten. Das Stellglied kann z.B. einen frequenzgesteuerten Sägezahngenerator 7 als Integrator für die eingegebene Stellgröße $\omega$ enthalten, wobei dem Integrator ein Funktionsgeber 8 zur Bildung von cos $\omega$ t, sin $\omega$ t nachgeschaltet ist. Die Ausgänge des Funktionsgebers 8 stellen somit die Transformationselemente bezüglich der stellgrößenproportionalen Frequenz $\omega$ dar.

Eine Transformationsschaltung 9 liefert nun aus den Transformationselementen und den Orthogonalkomponenten eine richtungsbestimmende GröMe des Raumzeigers. Die Transformationsschaltung 9 kann besonders einfach auf die angegebene Weise durch zwei Multiplizierer 10 und 11, durch die jeweils eine Orthogonalkomponente mit einem Transformationselement verknüpft wird, aufgebaut sein. In diesem Fall wird nur der Imaginärteil des Raumzeigers als richtungsbestimmende Größe gebildet, um als Istwert an einer Regelvergleichsstelle 13 mit dem entsprechenden Sollwert Null für die Richtung des Raumzeigers verglichen zu werden. Dabei kann es vorteilhaft sein, der Transformationsschaltung 9 eine Normierungsschaltung nachzuschalten, die den Betrag des Raumzeigers, der im allgemeinen Fall durch $\sqrt{\hat{g}_\alpha{}^2 + \hat{g}_\beta{}^2}$ gegeben ist, auf einen konstanten Betrag zu normieren. Der Ausgang dieser Normierungsschaltung g' stellt somit die Größe $I_m$ ($g_s$)/ $|g_s|$ dar, so daß durch diese Istwertvorgabe für den Regelvergleich eine konstante Regelverstärkung erreichbar ist.

Der Regelvergleichsstelle 13 ist ein von der Ist-Bollwert-Differenz beaufschlagter Regler 14 nachgeschaltet, der nunmehr die Eingangsgröße ("Stellgröße") für das Stellglied 5 liefert. Vorteilhaft kann dabei vorgesehen sein, an einer Überlagerungsstelle 16 das Reglerausgangssignal mit dem Nennwert der Netzfrequenz zu überlagern, so daß der Regler nur die Abweichungen von der Nennfrequenz auszuregeln braucht.

Als Frequenzmeßwert kann nun die Stellgröße $\omega$ über die Leitung 17 direkt an der Vorrichtung abgegriffen werden, wobei es vorteilhaft sein kann, mittels eines Differenzierers 18 am Reglerausgang auch die zeitliche Ableitung des Reglerausgangssignals zu bilden, um ein Maß für die Beschleunigung des Mitsystems zu erhalten. Dadurch ist es möglich, aus Frequenz und Beschleunigung oder ggf. einem Meßwert für den Betrag der Mitkomponente eine für die Leistungsbilanz der elektrischen Übertragung charakteristische Mischgröße zu bilden.

Der Regler kann vorteilhaft einen integrierenden Anteil besitzen, um die Richtungsabweichung des Raumzeigers vollkommen auszuregeln. Im stationären Fall regelt der Regler dann die mittlere Richtungsabweichung des Raumzeigers und mittelt somit Oberschwingungen und ein Gegensystem selbsttätig aus. Das dynamische Verhalten des Reglers braucht nicht auf die Netzfrequenz besonders abgestimmt zu werden, vielmehr kann der Regler durch entsprechenden Eingriff in seiner Beschaltung bezüglich seines dynamischen Verhaltens an die jeweiligen Erfordernisse angepaßt werden. Je nachdem, ob die Meßaufgabe eine hohe Genauigkeit oder eine kurze Einstellzeit verlangt, kann der integrierende Anteil des Reglers größer oder kleiner eingestellt werden.

Bei der in Fig. 2 gezeigten digitalisierten Ausführung liefert der Koordinatenwandler 4 die Orthogonalkomponenten als Analogspannungen an den Analogeingang eines im Multiplexbetrieb arbeitenden Abtastmultiplizierers 20, der als Transformationsschaltung gleichzeitig die Imaginärteilbildung und ggf. die Normierung durchführt. Der Regelvergleichsstelle 13 ist der Sollwert Null eingegeben. Mit der Ausgangsgröße des Reglers 14 wird ein spannungsgesteuerter Oszillator 21 angesteuert, dessen Eingangsgröße noch um den fest vorgegebenen Wert der Nennfrequenz $\omega_N$ erhöht wird. Seine Ausgangsgröße ist die frequenzproportionale Impulsfolge $\omega = \omega_N + \delta$, die

einem integrierend wirkenden Zähler zur Erzeugung einer Sägezahnspannung zugeführt wird. Das m-bit-Ausgabewort des Zählers 22, das einer Zerlegung einer Periode in $2^m$-Zeifstufen entspricht, adressiert einen Festwertspeicher 8, dessen n-bit-Ausgabe wort sin $\omega$ t und cos $\omega$ t darstellt und dem Digitaleingang des Abtastmultiplizierers 20 zugeführt ist.

Die zur Steuerung der Multiplex- und Abtastoperationen benötigten Schaltsignale der Arbeitsfrequenz $f_s$ werden einem weiteren Festwertspeicher 23 entnommen, den ein $2^k$-stufiger, synchron anlaufender Zähler 24 für die Ausgangsimpulse des Oszillators 21 adressiert. Zur Frequenzmessung werden an einem Impulsgenerator 25 Impulse erzeugt, deren Dauer $\Delta$ T vorgegeben ist. Die während dieser Dauern $\Delta$ T anfallenden Impulse des Oszillators 21 werden in einem Zähler 26 addiert, dessen Zählerstand an einer Anzeige 27 abgelesen werden kann.

Die Einrichtung läßt sich für beliebige mehrphasige Größen verwenden, beispielsweise für Spannungen, Ströme, Flüsse und Ladungen. Sie kann nicht nur für 3-phasige, sondern sinngemäß auch für höherphasige Wechselstromsysteme vorgesehen werden. Je nach dem Verwendungszweck können manche Teile weggelassen oder ergänzt werden. So kann z.B. in Fällen, in denen das Mitsystem eine annähernd konstante Größe hat, auf eine Normierung des Raumzeigers verzichtet werden. Andererseits kann man auch für 3-Phasen-Frequenzmesser, mit denen bei Leistungsdefizit die Last abgeworfen werden soll, den Betrag der Mitspannung als Stör-größe am Addierer 16 aufschalten.

Schließlich kann die Erfindung auch vorteilhaft zur Messung des von einem Drehstrommotor ausgeübten Drehmomentes erweitert werden. Hierzu bildet man mit bekannten Multiplikatorschaltungen den Augenblickswert der Motor-Klemm-

## Patentansprüche

1. Verfahren zur Frequenzmessung an einem mehrphasigen Leitungssystem zur elektrischen Leistungsübertragung, dadurch gekennzeichnet,
- daß aus am Leitungssystem (R, S, T) abgegriffenen Meß-werten ($u_R$, $u_S$, $u_T$) die einer raumfesten Betrachtung zugrunde gelegten Orthogonalkomponenten ($g\alpha$, $g\beta$) des nullpunktfreien Meßwertsystems und aus einer Stell-größe ($\omega$) zwei mit einer der Stellgröße proportionalen Frequenz veränderliche Elemente einer Transformationsmatrix gebildet werden,
- daß aus den Orthogonalkomponenten und den Transformationselementen eine richtungsbestimmende Größe (Im ($g_s$)) des den Orthogonalkomponenten zugeordneten Raumzeigers ($g_s$) gebildet wird,
- daß durch Vorgabe eines Sollwertes für die richtungsbestimmende Größe des Raumzeigers die Stellgröße so geregelt wird, daß der gegebenenfalls zeitlich gemittelte Raumzeiger stets dieselbe Richtung aufweist, und
- daß die Stellgröße als Meßgröße der Frequenz abgegriffen ist.

2. Verfahren nach Anspruch 1, dadurch gekennzeichnet, daß als richtungsbestimmende Größe des Raumzeigers dessen Real- oder Imaginärteil und als Sollwert der Wert Null gewählt wird.

3. Vorrichtung zur Durchführung des Verfahrens nach Anspruch 1, gekennzeichnet durch
- ein am Leitungssystem angeordnetes Meßglied (3R, 3S, 3T; 4), das praktisch unverzögert die raumfesten Orthogonalkomponenten eines dem Leitungssystem zugeordneten nullpunktfreien Systems liefert,
- ein einen integrierenden Funktionsgeber (7, 8) enthaltendes Stellglied (5), das aus dem zeitlichen Integral leistung und korrigiert diese mit den simulierten Wicklungs- und Eisenverlusten des Ständers. Durch Division mit der auf die beschriebene Weise gewonnenen Kreisfrequenz des Drehfeldes erhält man ein Maß für den Augenblickswert des Drehmomentes. einer Stellgröße die Transformationselemente (cos $\omega$t, sin $\omega$ t) für eine Transformation der raumfesten Orthogonalkomponenten in den zugeordneten Raumzeiger bezüglich eines der stellgrößenproportionalen Frequenz zugeordneten Bildraumes liefert,
- eine Transformationsschaltung (g), die aus den Transformationselementen und den Orthogonalkomponenten eine richtungsbestimmende Größe des Raumzeigers liefert,
- einen von der richtungsbestimmenden Größe als Istwert und einem konstanten Sollwert beaufschlagten Regler (14) zur Bildung der Stellgröße, und
- einer Ausgabeleitung (17) für die Stellgröße als Frequenzmeßgröße.

4. Vorrichtung nach Anspruch 3, gekennzeichnet durch eine der Transformationsschaltung nachgeschaltete Normierungsschaltung (g') zur Normierung des Raumzeigerbetrages.

5. Vorrichtung nach Anspruch 3 oder 4, gekennzeichnet durch einen integrierenden Anteil des Reglers.

6. Vorrichtung nach Anspruch 5, gekennzeichnet durch ein einstellbares dynamisches Verhalten des Reglers.

7. Vorrichtung nach einem der Ansprüche 3 bis 6, gekennzeichnet durch einen an die Ausgabeleitung angeschlossenen Differenzierer.

8. Verwendung der Vorrichtung nach einem der Ansprüche 3 bis 7 zur Bildung einer die Leistungsbilanz der elektrischen Übertragung charakterisierenden Mischgröße aus der gemessenen Frequenz und der zeitlichen Änderung der Frequenz oder dem Betrag der Mitkomponente.

9. Verwendung der Vorrichtung nach einem der Ansprüche 3 bis 7 zur Bildung einer dem Quotient aus der momentanen gemessenen, um simulierte Wicklungs- und Eisenverluste korrigierten Klemmenleistung eines Drehstrommotors und der Meßgröße der Frequenz proportionalen Größe als das Drehmoment des Motors charakterisierende Größe.


**Claims:**

1. A process for frequency measurement in a polyphase line system for electric power transmission, characterised in
- that zero-free measured value system orthogonal components $(g_\alpha, g_\beta)$ based on a fixed space observation are formed from measured values $(u_R, u_S, u_T)$ tapped from the line system $(R, S, T)$, and two elements of a transformation matrix variable by a frequency proportional to the correcting variable are formed from a correcting variable $(\omega)$,
- that a direction-determining magnitude $(Im(g_s))$ of the space indicator $(g_s)$ assigned to the orthogonal components is formed from the orthogonal components and the transformation elements,
- that the correcting variable is controlled by specifying a theoretical value for the direction-determining magnitude of the space indicator in such a manner that the space indicator, possibly averaged in terms of time, always has the same direction, and
- that the correcting variable is tapped as a measured variable of the frequency.

2. A process as claimed in Claim 1, characterised in that the real or imaginary component of the space indicator is selected as direction-determining magnitude and the value zero is selected as theoretical value.

3. A device for implementation of the process as claimed in Claim 1, characterised by
- a measuring element (3R,3S,3T; 4) arranged at the line system, which supplies space-bound orthogonal components of a zero-free system assigned to the line system in a virtually undelayed fashion,
- a correcting variable (5) which comprises an integrated function indicator (7,8) and which supplies the transformation elements (cos ωt, sin ωt) for a transformation of the space-bound orthogonal components into the assigned space indicator relative to an image space assigned to the frequency proportional to the correcting variable from the time integral of a correcting variable,
- a transformer circuit (g) which supplies a directiondetermining magnitude of the space indicator frcm the transformation elements and the orthogonal ccmponents,
- a regulator (14) acted upon by the directiondetermining magnitude as an actual value and a constant theoretical value, which serves to form the correcting magnitude, and
- an output line (17) for the correcting variable as a measured variable of the frequency.

4. A device as claimed in Claim 3, characterised by a standardisation circuit (g') connected following the transformation circuit which serves to standardise the amount of the space indicator.

5. A device as claimed in Claim 3 or 4, characterised by an integrating component of the regulator.

6. A device as claimed in Claim 5, characterised by an adjustable dynamic regulator characteristic.

7. A device as claimed in one of Claims 3 to 8, characterised by a differentiator connected to the output line.

8. Use of the device as claimed in one of Claims 3 to 7 for the formation of a mixed quantity characterising the power rating of the electric transmission from the measured frequency and the change in frequency in terms of time or the amount of the associated component.

9. Use of the device as claimed in one of Claims 3 to 7 for the formation of a magnitude as a magnitude which characterises the torque of the motor, which magnitude is proportional to the quotient of the instantaneous measured terminal output of a three-phase current motor, corrected by simulated winding and iron losses, and the measured variable of the frequency.


**Revendications**

1. Procédé pour mesurer la fréquence dans un système polyphasé de conducteurs servant au transport d'énergie électrique, caractérisé par le fait:
- qu'à partir de valeurs de mesure $(u_R, u_S, u_T)$ qui sont prélevées dans le système de conducteurs $(S, R, T)$, on forme les composantes orthogonales $(g_\alpha, g_\beta)$, prises pour base dans le cas d'une observation fixe dans l'espace du système de valeurs de mesure ne comportant pas de point zéro et à partir d'une grandeur de réglage $(\omega)$, on forme deux éléments, variables avec une fréquence proportionnelle à la grandeur de réglage, d'une matrice de transformation,
- qu'à partir des composantes orthogonales et des éléments de transformation, on forme une grandeur $(Im (g_s))$ déterminant le sens du vecteur spatial $(g_s)$ associé aux composantes orthogonales,
- que, moyennant la prédétermination d'une valeur de consigne pour la grandeur, déterminant le sens, du vecteur spatial, on règle la grandeur de réglage de telle sorte que
-le vecteur spatial, dont la moyenne est éventuellement formée dans le temps, indique toujours la même direction, et
- que la grandeur de réglage est prélevée en tant que grandeur de mesure de la fréquence.

2. Procédé suivant la revendication 1, caractérisé par le fait que l'on choisit comme grandeur, déterminant la direction du vecteur spatial, la partie réelle ou imaginaire de ce dernier et que l'on choisit comme valeur de consigne la valeur zéro.

3. Dispositif pour la mise en oeuvre du procédé selon la revendication 1, caractérisé par:

- un organe de mesure (3R, 3S, 3T; 4) monté dans le système de conducteurs et qui fournit, pratiquement sans retard, les composantes orthogonales, fixes dans l'espace, d'un système ne comportant pas de point zéro et associé au système de conducteurs,

- un organe de réglage (5), qui contient un générateur de fonctions (7, 8) à intégration et qui fournit, à partir de l'intégrale dans le temps d'une grandeur de règlage, les éléments de transformation (cosωt, sin ω t) pour une transformation des composantes orthogonales fixes dans l'espace, fournissant le vecteur spatial associé, par rapport à un espace image associé à la fréquence proportionnelle à la grandeur de réglage,

- un circuit de transformation (g) qui fournit, à partir des éléments de transformation et de composantes orthogonales, une grandeur, déterminant le sens, du vecteur spatial,

- un régulateur (14) qui est chargé par la grandeur déterminant la direction, en tant que valeur réelle, et par une valeur de consigne constante et qui sert à former la grandeur de réglage, et

- un conducteur de sortie (17) délivrant la grandeur de réglage sous la forme d'une grandeur de mesure de la fréquence.

4. Dispositif suivant la revendication 3, caractérisé par un circuit de normalisation (g') branché en aval du circuit de transformation et servant à normaliser la valeur du vecteur spatial.

5. Dispositif suivant la revendication 3 ou 4, caractérisé par une partie, réalisant une intégration, du régulateur.

6. Dispositif suivant la revendication 5, caractérisé par un comportement dynamique réglable du régulateur.

7. Dispositif suivant l'une des revendications 3 à 6, caractérisé par un circuit différentiateur raccordé au conducteur de sortie.

8. Application du dispositif suivant l'une des revendications 3 à 7 à la formation d'une grandeur mixte, caractéristique du bilan énergétique de la transmission électrique, à partir de la fréquence mesurée et de la variation dans le temps de la fréquence ou de la valeur de la composante directe.

9. Application du dispositif suivant l'une des revendications 3 à 7 à la formation du quotient entre la puissance aux bornes d'un moteur à courant triphasé, mesurée instantanément et corrigée des pertes simulées dans les enroulements et des pertes simulées dans le fer et la valeur de mesure de la grandeur proportionnelle à la fréquence et servant de grandeur caractérisant le couple de rotation du moteur.

0 117 421

1/2

FIG 1

FIG 2